# EUROPEAN PATENT APPLICATION

(11) **EP 2 843 701 A1**
(43) Date of publication of application: **04.03.2015**
(21) Application number: 14156546.5
(22) Date of filing: 25.02.2014
(51) Int. Cl.: H01L 25/075, H01L 33/50, H01L 33/64

(54) **Light emitting device**

(30) Priority: 30.08.2013 JP 2013180679
(71) Applicant: Toshiba Lighting & Technology Corporation, Yokosuka-shi Kanagawa 237-8510 (JP)
(72) Inventor: Tanaka, Hirotaka, Kanagawa, 237-8510 (JP); Nishimura, Kiyoshi, Kanagawa, 237-8510 (JP); Shimokawa, Kazuo, Kanagawa, 237-8510 (JP); Sasaki, Akihiro, Kanagawa, 237-8510 (JP); Habutsu, Akiyoshi, Kanagawa, 237-8510 (JP)
(74) Representative: Bokinge, Ole

(57) **Abstract**

According to an embodiment, a light emitting device (110, 110a) including a substrate (10), a plurality of semiconductor light emitting elements (20) and a wavelength conversion layer (31) is provided. The semiconductor light emitting elements (20) are provided on the substrate (10). The wavelength conversion layer (31) covers the semiconductor light emitting elements (20) and converts a wavelength of light emitted from the plurality of semiconductor light emitting elements (20). A first distance (L1) between an upper surface (31u) of the wavelength conversion layer (31) in a first region (R1) between two adjacent semiconductor light emitting elements (20) in the semiconductor light emitting elements (20) and the substrate (10) is shorter than a second distance (L2) between the upper surface (31u) of the wavelength conversion layer (31) and the substrate (10) in a second region (R2) on the two adjacent semiconductor light emitting elements (20).

## Description

### FIELD

Embodiments described herein relate generally to a light emitting device.

### BACKGROUND

For example, there is a light emitting device that is configured to emit white light by combining a semiconductor light emitting element that emits blue light and a fluorescent body that converts a wavelength of the light. In such a light emitting device, it is preferable that reliability be improved.

### BRIEF DESCRIPTION OF THE DRAWINGS

FIG. 1A to FIG. 1C are schematic views illustrating a light emitting device and a lighting device according to a first embodiment;
FIG. 2 is a schematic cross-sectional view illustrating the light emitting device according to the first embodiment;
FIG. 3 is a schematic cross-sectional view illustrating a light emitting device according to a second embodiment;
FIG. 4A to FIG. 4G are schematic views illustrating a light emitting device according to a third embodiment;
FIG. 5A to FIG. 5C are schematic views illustrating the light emitting device according to the embodiment, and
FIG. 6 is a graph illustrating characteristics of the light emitting device according to the embodiment.

### DETAILED DESCRIPTION

According to an embodiment, a light emitting device including a substrate, a plurality of semiconductor elements and a wavelength conversion layer is provided. The semiconductor light emitting elements are provided on the substrate. The wavelength conversion layer covers the semiconductor light emitting elements and converts a wavelength of light emitted from the semiconductor light emitting elements. A first distance between an upper surface of the wavelength conversion layer and the substrate in a first region between two adjacent semiconductor light emitting elements in the semiconductor light emitting elements is shorter than a second distance between the upper surface of the wavelength conversion layer and the substrate in a second region on the two adjacent semiconductor light emitting elements.

Various embodiments will be described hereinafter with reference to the accompanying drawings.

Moreover, the drawings are schematic or conceptual and a relationship between a thickness and a width of each portion, a ratio of a size between portions, or the like is not necessarily limited to the same as that in reality. Further, even if the same portions are indicated in drawings, dimensions or ratios thereof may be indicated differently from each other depending on the drawings.

Moreover, in the specification and each view of the application, the same reference numerals are given to similar elements described already in the foregoing drawings and detailed description thereof is appropriately omitted.

### First Embodiment

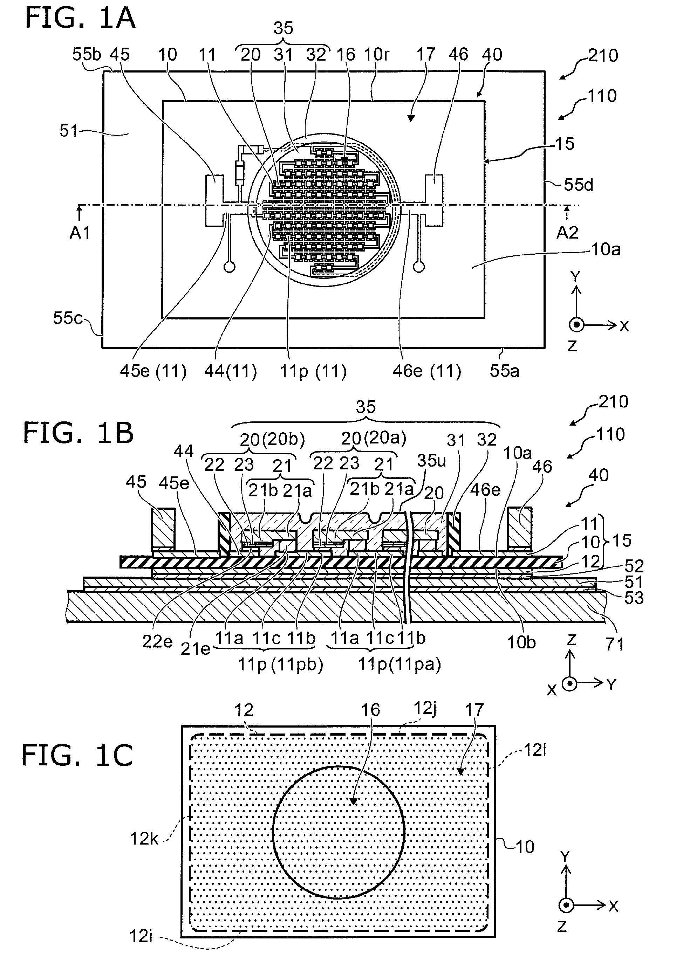

FIG. 1A to FIG. 1C are schematic views illustrating a light emitting device and a lighting device according to a first embodiment.

FIG. 1A is a plan view. FIG. 1B is a cross-sectional view illustrating a part of a cross-section along line A1-A2 of FIG. 1A.

As illustrated in FIG. 1A and FIG. 1B, a light emitting device 110 according to an embodiment includes a base member 71, a grease layer 53, a metal plate 51, a bonding layer 52, a mounting substrate section 15 and a plurality of semiconductor light emitting elements 20. The light emitting device 110 is, for example, utilized in a lighting device 210.

A direction from the base member 71 to the mounting substrate section 15 is referred to as a laminating direction (a Z-axis direction). One direction perpendicular to the Z-axis direction is referred to as an X-axis direction. A direction perpendicular to the Z-axis direction and the X-axis direction is referred to as a Y-axis direction.

The grease layer 53, the metal plate 51, the bonding layer 52, the mounting substrate section 15 and the plurality of semiconductor light emitting elements 20 are disposed on the base member 71 in this order.

That is, the plurality of semiconductor light emitting elements 20 are separated from the base member 71 in the Z-axis direction. The mounting substrate section 15 includes a substrate 10. The substrate 10 has an upper surface 10ue. For the substrate 10, for example, a member formed of ceramic, a composite ceramic of ceramic and resin or the like is used. For the ceramic, for example, aluminum oxide (Al₂O₃), aluminum nitride (AIN), beryllium oxide (BeO), steatite (MgO·SiO₂), zircon (ZrSiO₄), silicon nitride (Si₃N₄), or the like is used. The substrate 10 is provided between the base member 71 and the plurality of semiconductor light emitting elements. The metal plate 51 is provided between the base member 71 and the mounting substrate section 15.

As illustrated in FIG. 1B, the bonding layer 52 is provided between the mounting substrate section 15 and the metal plate 51. The bonding layer 52 bonds the mounting substrate section 15 to the metal plate 51.

The grease layer 53 is provided between the base member 71 and the metal plate 51. The grease layer 53 transmits heat of the metal plate 51 to the base member 71.

Hereinafter, an example of the light emitting device 110 (and a lighting device 210) shown in FIG. 1A and FIG. 1B is described.

A light emitting section 40 is provided in the light emitting device 110. The light emitting section 40 is provided on the metal plate 51. The bonding layer 52 is provided between the metal plate 51 and the light emitting section 40.

In the specification of the application, a state of being provided above also includes a state in which another element is inserted, in addition to the state of being provided above directly.

A direction from the metal plate 51 to the light emitting section 40 corresponds to the laminating direction. In the specification of the application, a state of being laminated also includes a state in which another element is inserted and overlapped in addition to a state of being overlapped directly.

The metal plate 51 is, for example, a plate-shape. A main surface of the metal plate 51 is, for example, substantially parallel to an X-Y plane. A planar shape of the metal plate 51 is, for example, rectangular. The metal plate 51 has, for example, first to fourth sides 55a to 55d. The second side 55b is separated from the first side 55a. The third side 55c connects an end of the first side 55a and an end of the second side 55b. The fourth side 55d is separated from the third side 55c and connects the other end of the first side 55a and the other end of the second side 55b. A plane-shaped corner section of the metal plate 51 may be curved. A plane shape of the metal plate 51 may not be rectangular and is optional.

For the metal plate 51, for example, a substrate formed of a metal material such as copper or aluminum or a composite material of metal and ceramic. Another metal layer such as Ni plating may be formed on a surface of the metal plate 51, from the viewpoint of preventing oxidation of the member and improving wettability of a solder.

The light emitting section 40 emits light. At the same time, the light emitting section 40 generates heat. The bonding layer 52 efficiently conducts the heat generated in the light emitting section 40 to the metal plate 51. For the bonding layer 52, for example, the solder or the like is used. That is, the bonding layer 52 includes the solder. For example, for the bonding layer 52, the solder including at least one kind or more of gold, silver, copper, bismuth, nickel, indium, zinc, antimony, germanium and silicon in a base of tin can be used. For example, SnAgCu alloy or the like is used.

The light emitting section 40 includes the mounting substrate section 15 and a light emitting element section 35.

The mounting substrate section 15 includes the substrate 10, a first metal layer 11 and a second metal layer 12.

The substrate 10 has a first main surface 10a and a second main surface 10b. The second main surface 10b is a surface on the side opposite the first main surface 10a. The metal plate 51 faces the second main surface of the substrate 10. In other words, the second main surface 10b is a surface on the side of the metal plate 51. That is, the second main surface 10b is a surface on the side of the bonding layer 52.

In the specification of the application, a state of facing also includes a state in which another element is inserted, in addition to a state of facing directly.

The first main surface 10a includes a mounting region 16. For example, the mounting region 16 is separated from an outer edge 10r of the first main surface 10a. In the example, the mounting region 16 is provided in a center portion of the first main surface 10a. The first main surface 10a further includes a peripheral region 17. The peripheral region 17 is provided around the mounting region 16.

The substrate 10 includes, for example, alumina. For the substrate 10, for example, a ceramic mainly composed of alumina is used. High thermal conductivity and a high insulating property can be obtained. High reliability can be obtained.

The first metal layer 11 is provided on the first main surface 10a. The first metal layer 11 includes a plurality of mounting patterns 11p. The plurality of mounting patterns 11p are provided in the mounting region 16. At least two or more of the plurality of mounting patterns 11p are separated from each other. For example, at least one of the plurality of mounting patterns 11p is an island shape. Two of the plurality of mounting patterns 11p are independent of each other. The plurality of mounting patterns 11p include, for example, a first mounting pattern 11pa and a second mounting pattern 11pb or the like.

Each of the plurality of mounting patterns 11p includes, for example, a first mounting portion 11a and a second mounting portion 11b. In the example, the mounting pattern 11p further includes a third mounting portion 11c. The third mounting portion 11c is provided between the first mounting portion 11a and the second mounting portion 11b, and connects the first mounting portion 11a and the second mounting portion 11b. Examples of the mounting portions are described below.

The first metal layer 11 may further include a connection section 44 connecting the plurality of mounting patterns 11p to each other. In the example, the first metal layer 11 further includes a first connector electrode section 45e and a second connector electrode section 46e. The first connector electrode section 45e is electrically connected to one of the plurality of mounting patterns 11p. The second connector electrode section 46e is electrically connected to another one which is different from the one of the plurality of mounting patterns 11p. For example, the semiconductor light emitting element 20 is disposed on a part of one mounting pattern 11p. The first connector electrode section 45e is electrically connected to one of the mounting patterns 11p by the semiconductor light emitting element 20. Further, the semiconductor light emitting element 20 is disposed on a part of another mounting pattern 11p. The second connector electrode section 46e is electrically connected to another mounting pattern 11p by the semiconductor light emitting element 20.

In the example, the light emitting section 40 further includes a first connector 45 and a second connector 46 provided on the first main surface 10a. The first connector 45 is electrically connected to the first connector electrode section 45e. The second connector 46 is electrically connected to the second connector electrode section 46e. In the example, the first connector 45 is provided on the first connector electrode section 45e. The second connector 46 is provided on the second connector electrode section 46e. The light emitting element section 35 is disposed between the first connector 45 and the second connector 46. Power is supplied to the light emitting section 40 through the connectors.

The second metal layer 12 is provided on the second main surface 10b. The second metal layer 12 is electrically insulated from the first metal layer 11. At least a part of the second metal layer 12 overlaps the mounting region 16 when projecting in the X-Y plane (a first plane parallel to the first main surface 10a).

FIG. 1C is a perspective plan view illustrating a part of the light emitting device 110.

The second metal layer 12 is separated from the outer edge 10r. A planar shape of the second metal layer 12 is, for example, rectangular. The second metal layer 12 has first to fourth sides 12i to 121. The second side 12j is separated from the first side 12i. A third side 12k connects an end of the first side 12i and an end of the second side 12j. The fourth side 121 is separated from the third side 12k and connects the other end of the first side 12i and the other end of the second side 12j. An intersecting point of each side, that is, a corner section may be a curved shape (a rounded shape). A planar shape of the second metal layer 12 may not be rectangular and is optional.

As described above, the first metal layer 11 is provided on the upper surface (the first main surface 10a) of the substrate 10 and the second metal layer 12 is provided on a lower surface (the second main surface 10b) of the substrate 10.

The light emitting element section 35 is provided on the first main surface 10a of the substrate 10. The light emitting element section 35 includes the plurality of semiconductor light emitting elements 20 and a wavelength conversion layer 31.

In the example, the plurality of semiconductor light emitting elements 20 are disposed in an array shape. The semiconductor light emitting elements 20 are, for example, disposed in a substantially circular shape. For example, the semiconductor light emitting elements 20 are disposed in a substantially equal pitch.

The plurality of semiconductor light emitting elements 20 are provided on the first main surface 10a. Each of the plurality of semiconductor light emitting elements 20 emits the light. For example, the semiconductor light emitting element 20 includes a nitride semiconductor. The semiconductor light emitting element 20 includes, for example, In_{y}Al_{z}Ga_{1-x-y}N (0≤x≤1, 0≤y≤1, x+y≤1). However, in the embodiment, the semiconductor light emitting element 20 is optional.

The plurality of semiconductor light emitting elements 20 include, for example, a first semiconductor light emitting element 20a, a second semiconductor light emitting element 20b, or the like.

Each of the plurality of semiconductor light emitting elements 20 is electrically connected to one mounting pattern 11p in the plurality of mounting patterns 11p and to another which is adjacent to the one mounting pattern 11p in the plurality of mounting patterns 11p.

For example, the first semiconductor light emitting element 20a is electrically connected to the first mounting pattern 11pa and the second mounting pattern 11pb in the plurality of mounting patterns 11p. The second mounting pattern 11pb is equivalent to another mounting pattern 11p which is adjacent to the first mounting pattern 11pa.

For example, each of the plurality of semiconductor light emitting elements 20 includes a first semiconductor layer 21 of a first conductive type, a second semiconductor layer 22 of a second conductive type and a light emitting layer 23. For example, the first conductive type is an n-type and the second conductive type is a p-type. The first conductive type may be the p-type and the second conductive type may be the n-type.

The first semiconductor layer 21 includes a first portion (a first semiconductor portion 21a) and a second portion (a second semiconductor portion 21b). The second semiconductor portion 21b lines up with the first semiconductor portion 21a in a direction (for example, the X-axis direction) intersecting the laminating direction (the Z-axis direction from the metal plate 51 toward the light emitting section 40).

The second semiconductor layer 22 is provided between the second semiconductor portion 21b and the mounting substrate section 15. The light emitting layer 23 is provided between the second semiconductor portion 21b and the second semiconductor layer 22.

The semiconductor light emitting element 20 is, for example, a flip-chip type LED.

For example, the first semiconductor portion 21a of the first semiconductor layer 21 faces the first mounting portion 11a of the mounting pattern 11p. The second semiconductor layer 22 faces the second mounting portion 11b of the mounting pattern 11p. The first semiconductor portion 21a of the first semiconductor layer 21 is electrically connected to the mounting pattern 11p. The second semiconductor layer 22 is electrically connected to another mounting pattern 11p. For the connection, for example, the solder, a gold bump having high electric conductivity and thermal conductivity, or the like is used. The connection is, for example, performed by a metal melting solder bonding. Otherwise, for example, the connection is performed by an ultrasonic thermo-compression bonding method using the gold bump.

That is, for example, the light emitting element section 35 further includes a first bonding metal member 21e and a second bonding metal member 22e. The first bonding metal member 21e is provided between the first semiconductor portion 21a and one mounting pattern 11p (for example, the first mounting portion 11a). The second bonding metal member 22e is provided between the second semiconductor layer 22 and another mounting pattern 11p (for example, the second mounting pattern 11pb). At least one of the first bonding metal member 21e and the second bonding metal member 22e includes the solder or the gold bump. Therefore, each cross-sectional area (a cross-sectional area when cutting in the X-Y plane) of the first bonding metal member 21e and the second bonding metal member 22e can be increased. Therefore, heat can be efficiently transmitted to the mounting substrate section 15 through the first bonding metal member 21e and the second bonding metal member 22e and heat radiation is improved.

For example, another metal layer may be provided between the semiconductor light emitting element 20 and the mounting substrate section 15. Therefore, oxidation of the first metal layer can be suppressed or wettability of the solder can be enhanced. The metal layer is not electrically connected to the semiconductor light emitting element 20 and the mounting pattern 11p. The metal layer is not related to a circuit.

The wavelength conversion layer 31 covers at least a part of the plurality of semiconductor light emitting elements 20. The wavelength conversion layer 31 absorbs at least a part of the light (for example, a first light) emitted from the plurality of semiconductor light emitting elements 20, and emits a second light. A wavelength (for example, a peak wavelength) of the second light is different from a wavelength (for example, a peak wavelength) of the first light. For example, the wavelength conversion layer 31 includes a plurality of wavelength conversion particles such as fluorescent body and a light-transmitting resin in which a plurality of wavelength conversion particles are dispersed. The first light includes, for example, blue light. The second light includes light whose wavelength is longer than that of the first light. For example, the second light includes at least one of yellow light and red light.

In the example, the light emitting element section 35 further includes a reflecting layer 32. The reflecting layer 32 surrounds the wavelength conversion layer 31 in the X-Y plane. The reflecting layer 32 includes, for example, a plurality of particles such as a metal oxide and a light transmitting resin in which the particles are dispersed. The particles such as the metal oxide have light reflective properties. For the particles such as the metal oxide, for example, at least one of TiO₂ and Al₂O₃ can be used. The light emitted from the semiconductor light emitting element 20 can be efficiently emitted along a direction (for example, an upward direction) along the laminating direction by providing the reflecting layer 32.

The light emitting section 40 is, for example, a chip-on board (COB) type LED module.

In the embodiment, a luminous emittance of light emitted from the light emitting element section 35 (the plurality of semiconductor light emitting elements 20) is 10 lm/mm² (lumens/square millimeter) or more and 100 lm/mm² or less. Preferably, the luminous emittance is 20 lm/mm² or more. That is, in the embodiment, a ratio (the luminous emittance) for the light emitted from the light emitting element section 35 with respect to a light-emitting area is very high. In the specification of the application, the light-emitting area substantially corresponds to an area of the mounting region 16.

For example, the light emitting device 110 according to the embodiment is used in the lighting device 210 such as a projector.

For the grease layer 53, lubricant (grease) of liquid or solid, or the like is used. For the grease layer 53, for example, lubricant (insulating grease) having an insulating property, lubricant (conductive grease) having conductivity or the like is also used. The insulating grease includes, for example, silicone and ceramic particles which are dispersed in the silicone. The conductive grease includes, for example, silicone and metal particles which are dispersed in the silicone. In the conductive grease, for example, the thermal conductivity that is higher than that of the insulating grease is obtained. For example, heat of the light emitting element section 35 is transmitted to the base member 71 by the grease layer 53 and radiated.

In the light emitting device 110 according to the embodiment, for example, the metal plate 51 has an area of 5 times or more an area of the mounting region 16 when the metal plate 51 is projected in the X-Y plane. That is, in the embodiment, the area of the metal plate 51 is set to be a lot greater than that of the mounting region 16. Therefore, the heat generated in the light emitting element section 35 provided on the mounting region 16 spreads in an in-plane direction (an in-plane direction of the X-Y plane) by the metal plate 51 having a large area. Then, the heat spread in the in-plane direction is transmitted toward, for example, the base member 71 and is efficiently radiated.

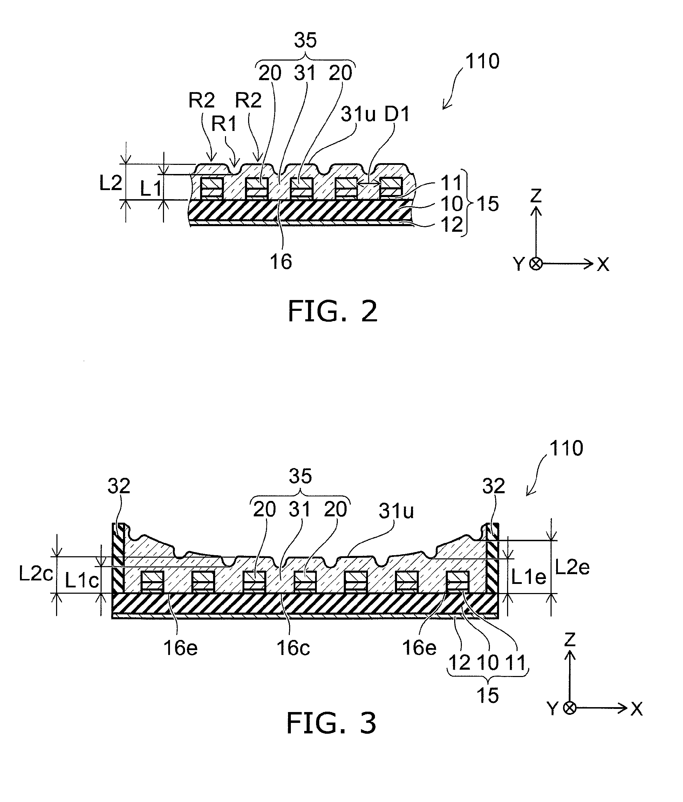

FIG. 2 is a schematic cross-sectional view illustrating the light emitting device according to the first embodiment.

FIG. 2 illustrates the light emitting element section 35 provided on the mounting region 16.

As illustrated in FIG. 2, the wavelength conversion layer 31 has an upper surface (a wavelength conversion layer upper surface 31u). As shown in FIG. 2, in the example, the wavelength conversion layer upper surface 31u is a concave shape in a region between the plurality of semiconductor light emitting elements 20.

The wavelength conversion layer upper surface 31u in the region on the semiconductor light emitting element 20 is positioned above the wavelength conversion layer upper surface 31u in a region between adjacent semiconductor light emitting elements 20.

For example, the region between two adjacent semiconductor light emitting elements 20 in the plurality of semiconductor light emitting elements 20 is referred to as a first region R1. The region on two adjacent semiconductor light emitting elements 20 is referred to as a second region R2.

A distance between the wavelength conversion layer upper surface 31u in the first region R1 and the substrate 10 is referred to as a first distance L1. A distance between the wavelength conversion layer upper surface 31u in the second region R2 and the substrate 10 is referred to as a second distance L2.

In the embodiment, the first distance L1 is shorter than the second distance L2.

That is, the concave section is provided on the wavelength conversion layer upper surface 31u in the region between the plurality of semiconductor light emitting elements 20.

In the embodiment, for example, the first distance L1 is not less than 0.55 mm and not more than 0.65 mm. The second distance L2 is, for example, not less than 0.6 mm not more than 0.7 mm. An absolute value of a difference between the first distance L1 and the second distance L2 is, for example, not less than 0.07 times and not more than 0.83 times the second distance L2. A height of the semiconductor light emitting element 20 is not less than 0.05 mm and not more than 0.60 mm.

The height of the wavelength conversion layer 31 in the first region R1 between adjacent semiconductor light emitting elements 20 corresponds to the first distance L1. The height of the wavelength conversion layer 31 in the second region on the semiconductor light emitting element 20 corresponds to the second distance L2. For example, the plurality of semiconductor light emitting elements 20 are provided in the array shape in the X-Y plane. For example, a surface shape of the wavelength conversion layer 31 may also be observed as a scale shape.

A part of the heat generated in the light emitting element section 35 is accumulated, for example, in the wavelength conversion layer 31. The heat accumulated in the wavelength conversion layer 31 is, for example, transmitted to the semiconductor light emitting element 20 and is radiated to the mounting substrate section 15. For example, the heat is accumulated in the wavelength conversion layer 31 in the region between the semiconductor light emitting elements 20. In the embodiment, the height of the wavelength conversion layer 31 in the region between the semiconductor light emitting elements 20 is low. Therefore, accumulation of the heat between the semiconductor light emitting elements 20 can be suppressed and heat radiation can be increased.

According to the embodiment, the light emitting device having high reliability in which the heat radiation is improved is provided.

### Second Embodiment

FIG. 3 is a schematic cross-sectional view illustrating a light emitting device according to a second embodiment.

FIG. 3 is a schematic cross-sectional view of a surface perpendicular to the Y-axis of the light emitting device 110. The mounting region 16 includes a center section 16c and an outer periphery section 16e.

A distance L2c is a distance from the wavelength conversion layer upper surface 31u to the substrate 10 in the region on the semiconductor light emitting element 20 which is provided in the center section 16c.

A distance L1c is a distance from the wavelength conversion layer upper surface 31u to the substrate 10 in the region between the adjacent semiconductor light emitting elements 20 which are provided in the center section 16c. The distance L1c is shorter than the distance L2c.

A distance L2e is a distance from the wavelength conversion layer upper surface 31u to the substrate 10 in the region on the semiconductor light emitting element 20 which is provided in the outer periphery section 16e.

A distance L1e is a distance from the wavelength conversion layer upper surface 31u to the substrate 10 in the region between adjacent semiconductor light emitting elements 20 which are provided in the outer periphery section 16e. The distance L1e is shorter than the distance L2e.

In the embodiment, the distance L1c is shorter than the distance L1e. That is, the first distance L1 (that is, the distance L1c) with respect to the semiconductor light emitting element 20 which is positioned in the center section 16c of the mounting region 16 is shorter than the first distance L1 (that is, the distance L1e) with respect to the semiconductor light emitting element 20 which is positioned in the outer periphery section 16e.

For example, the distance L1c is not less than 0.54 mm not more than 0.67 mm. The distance L1e is not less than 0.7 mm and not more than 0.8 mm. An absolute value of a difference between the distance L1c and the distance L1e is, for example, not less than 0.3 times not more than 0.45 times the distance L1c.

In the embodiment, the distance L2c is shorter than the distance L2e. That is, the second distance L2 (that is, the distance L2c) with respect to the semiconductor light emitting element 20 which is positioned in the center section 16c of the mounting region 16 is shorter than the second distance L2 (that is, the distance L2e) with respect to the semiconductor light emitting element 20 which is positioned in the outer periphery section 16e.

For example, the distance L2c is not less than 0.6 mm not more than 0.7 mm. The distance L2e is not less than 0.75 mm not more than 0.85 mm. An absolute value of difference between the distance L2c and the distance L2e is for example, not less than 0.2 times not more than 0.25 times the distance L2c.

A part of the heat generated in the light emitting element section 35 is accumulated, for example, in the wavelength conversion layer 31. For example, the heat is likely to be accumulated in the wavelength conversion layer 31 in the region on the center section 16c. In the embodiment, the height (the distance L1c) of the wavelength conversion layer 31 in the region on the center section 16c is lower than that (the distance L2c) of the wavelength conversion layer 31 in the region on the outer periphery section 16e. Then, the distance L2c is shorter than the distance L2e. Therefore, the accumulation of the heat in the wavelength conversion layer 31 in the region on the center section 16c can be suppressed. For example, a difference between a temperature of the semiconductor light emitting element 20 in the region on the center section 16c and a temperature of the semiconductor light emitting element 20 in the region on the outer periphery section 16e is small. According to the embodiment, the light emitting device having high reliability in which the accumulation of the heat is suppressed and the heat radiation is improved is provided.

### Third Embodiment

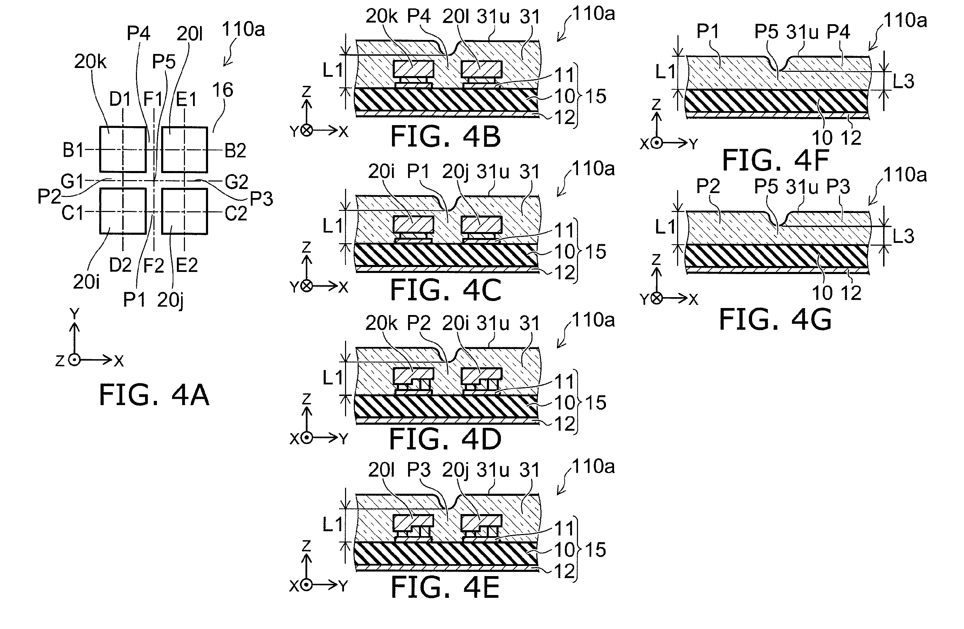

FIG. 4A to FIG. 4G are schematic views illustrating a light emitting device according to a third embodiment. FIG. 4A is a plan view of a part of the mounting region 16 of a light emitting device 110a according to the third embodiment.

FIG. 4B is a schematic cross-sectional view illustrating a cross-section along line B1-B2 of FIG. 4A.

FIG. 4C is a schematic cross-sectional view illustrating a cross-section along line C1-C2 of FIG. 4A.

FIG. 4D is a schematic cross-sectional view illustrating a cross-section along line D1-D2 of FIG. 4A.

FIG. 4E is a schematic cross-sectional view illustrating a cross-section along line E1-E2 of FIG. 4A.

FIG. 4F is a schematic cross-sectional view illustrating a cross-section along line F1-F2 of FIG. 4A.

FIG. 4G is a schematic cross-sectional view illustrating a cross-section along line G1-G2 of FIG. 4A.

As shown in FIG. 4A, in the light emitting device 110a, the plurality of semiconductor light emitting elements 20 are provided on the upper surface of the substrate 10. The plurality of semiconductor light emitting elements 20 include a first semiconductor element 20i, a second semiconductor element 20j, a third semiconductor element 20k and a fourth semiconductor element 201.

The second semiconductor element 20j is separated from the first semiconductor element 20i in a first direction (for example, the X-axis direction) parallel to the upper surface of the substrate 10.

The third semiconductor element 20k is separated from the first semiconductor element 20i in a second direction (for example, the Y-axis direction) which is parallel to the upper surface of the substrate 10 and intersecting the first direction.

The fourth semiconductor element 201 is separated from the third semiconductor element 20k in the X-axis direction and is separated from the second semiconductor element 20j in the Y-axis direction.

The wavelength conversion layer 31 covers the plurality of semiconductor light emitting elements 20. The wavelength conversion layer 31 includes a first portion P1, a second portion P2, a third portion P3, a fourth portion P4 and a fifth portion P5.

The first portion P1 is a region between the first semiconductor element 20i and the second semiconductor element 20j. The second portion P2 is a region between the first semiconductor element 20i and the third semiconductor element 20k. The third portion P3 is a region between the second semiconductor element 20j and the fourth semiconductor element 201. The fourth portion P4 is a region between the third semiconductor element 20k and the fourth semiconductor element 201. The fifth portion P5 is a region between the first portion P1 and the fourth portion P4, and between the second portion P2 and the third portion P3.

The first portion P1, the second portion P2, the third portion P3 and the fourth portion P4 are a region R1 which is provided in a region between adjacent semiconductor light emitting elements 20.

As shown in FIG. 4B, a distance between the wavelength conversion layer upper surface 31u and the substrate 10 in the fourth portion P4 is the first distance L1.

As shown in FIG. 4C, a distance between the wavelength conversion layer upper surface 31u and the substrate 10 in the first portion P1 is the first distance L1.

As shown in FIG. 4D, a distance between the wavelength conversion layer upper surface 31u and the substrate 10 in the second portion P2 is the first distance L1.

As shown in FIG. 4E, a distance between the wavelength conversion layer upper surface 31u and the substrate 10 in the third portion P3 is the first distance L1.

As shown in FIG. 4F and FIG. 4G, a distance between the wavelength conversion layer upper surface 31u and the substrate 10 in the fifth portion is a third distance L3.

In the light emitting device 110a according to the embodiment, the third distance L3 is shorter than the first distance L1.

The accumulation of the heat in the wavelength conversion layer 31 between the semiconductor light emitting elements 20 can be suppressed by making the third distance L3 shorter than the first distance L1. Therefore, the light emitting device having high reliability in which the heat radiation is improved is provided.

For example, the first portion P1 to fourth portion P4 are sandwiched between two semiconductor light emitting elements. Therefore, a part of the heat of those portions is radiated by a path through the semiconductor light emitting elements. Meanwhile, the fifth portion P5 is sandwiched by the first portion P1 to fourth portion P4 instead of the semiconductor light emitting elements. Thus, the heat of the fifth portion P5 is unlikely to be radiated. The heat of the fifth portion P5 is effectively radiated by making the height of the wavelength conversion layer 31 in the fifth portion P5 lower than those of the other portions.

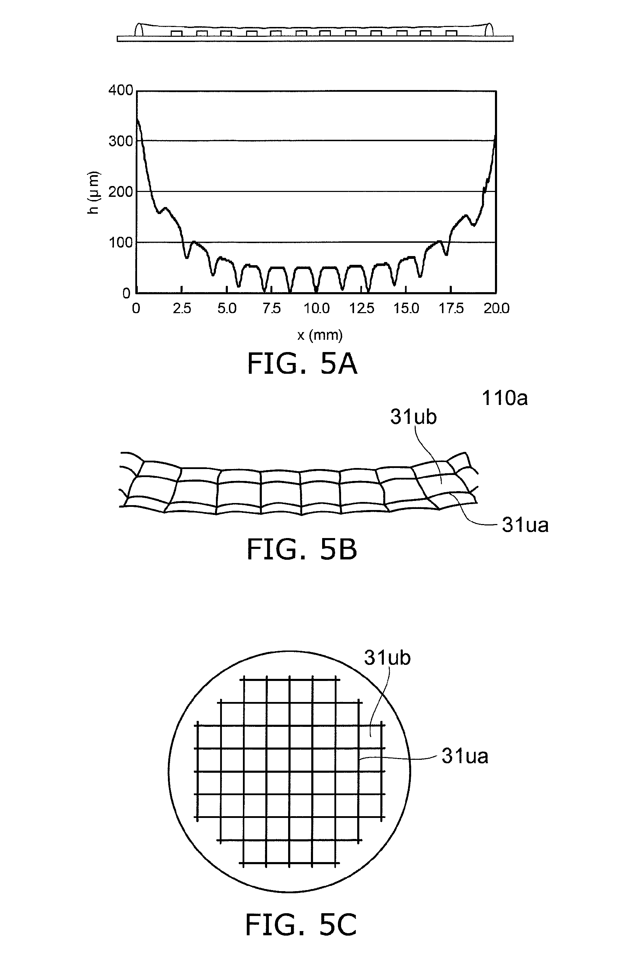

FIG. 5A to FIG. 5C are schematic views illustrating a light emitting device according to an embodiment.

FIG. 5A is a graph illustrating concavity and convexity of the wavelength conversion layer upper surface 31u in the X-Y plane of the light emitting device 110a.

A vertical axis of FIG. 5A is a height h of the wavelength conversion layer 31. A horizontal axis of FIG. 5A is, for example, a position x in the X-Y plane. The height h is a position in the Z-axis direction.

In the example, the height of the semiconductor light emitting element is 0.40 mm and an average value of the thickness (the distance from semiconductor light emitting element to the upper surface of the wavelength conversion layer) of the wavelength conversion layer 31 is 0.25 mm. In the example, the outer periphery section 16e is a region in which the position x is the vicinity of 0 mm to 7.0 mm and a region in which the position x is the vicinity of 13.0 mm to 20.0 mm. The center section 16c is a region in which the position x is the vicinity of 7.0 mm to 14.0 mm. In the center section 16c, a depth of the concave section is approximately 0.045 mm to 0.060 mm.

FIG. 5B is a schematic perspective view of the wavelength conversion layer 31 of the light emitting device 110a. Moreover, the view is obtained by changing the position x and measuring the reflected light while radiating light of optical laser into the light emitting element section.

FIG. 5C is a schematic plan view of the wavelength conversion layer 31 of the light emitting device 110a.

As shown in FIG. 5B and FIG. 5C, a concave section 31ua and a convex section 31ub are provided in the wavelength conversion layer upper surface 31u. A shape of the wavelength conversion layer upper surface 31u may be observed as a scale shape. Therefore, the light emitting device having high reliability in which the heat radiation is improved is provided.

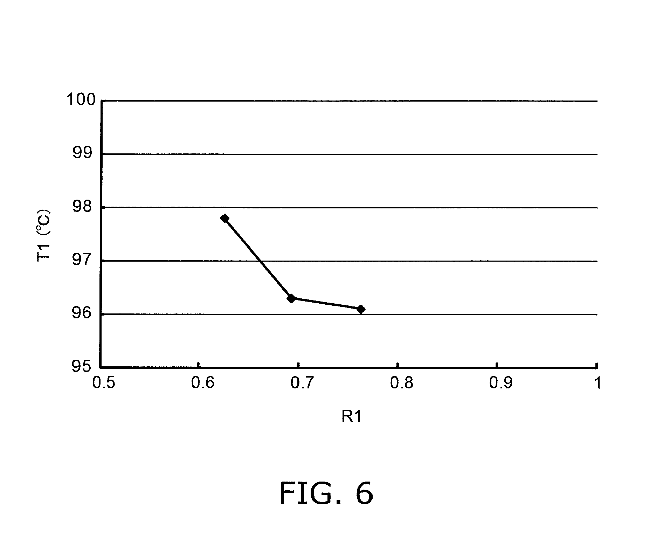

FIG. 6 is a graph illustrating characteristics of a light emitting device of according to embodiment.

FIG. 6 illustrates a temperature of the mounting region 16. A horizontal axis of FIG. 6 is a depth R1 of a concave section of the concavity and convexity of the wavelength conversion layer 31. The depth R1 is a ratio of an absolute value of a difference between the first distance L1 and the second distance L2 with respect to the second distance L2. That is, the depth R1 is |L2-L1|/L2. A vertical axis of FIG. 6 is a temperature T1 of a center section of the mounting region 16 when emitting the light.

The temperature T1 is 96.1°C when the depth R1 is 0.76.

The temperature T1 is 96.3°C when the depth R1 is 0.69.

The temperature T1 is 97.8°C when the depth R1 is 0.62.

The depth R1 is, for example, preferably 0.69 or more. The upper limit is 0.90. If the depth R1 is greater than 0.90, moving of the heat is suppressed between adjacent regions and imbalance of the heat may be caused.

Moreover, the concave section can be generated, for example, by pouring resin between electrodes on a lower side of a flip chip type LED or by a viscosity of the resin which is poured when manufacturing. A depth of the concave section affects those conditions, the height of the semiconductor light emitting element which is used, or the like.

According to the embodiment, the light emitting device having high reliability is provided.

Moreover, in the specification of the application, terms of "perpendicular" and "parallel" are not only strictly perpendicular and strictly parallel but also are intended to include variations thereof or the like, for example, in a manufacturing process, and may be substantially perpendicular and substantially parallel.

Above, the embodiments are described with reference to specific examples. However, the exemplary embodiment is not limited to the specific examples. For example, specific configurations of each element such as the semiconductor light emitting element, the wavelength conversion layer and the substrate are included within the scope of the exemplary embodiment as long as the configurations can be executed similar to the exemplary embodiment and the same effects can be obtained by those skilled in the art.

Further, that two or more elements of each specific example are combined in a technically possible range is included in the scope of the exemplary embodiment as long as the gist of the exemplary embodiment is included.

In addition, in the scope of the spirit of the exemplary embodiment, those skilled in the art can conceive various modification examples and alteration examples, and it is understood that the modification examples and the alteration examples belong within the scope of the exemplary embodiment.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting device (110, 110a) comprising:
a substrate (10);
a plurality of semiconductor light emitting elements (20) provided on the substrate (10); and
a wavelength conversion layer (31) covering the semiconductor light emitting elements (20) and configured to convert a wavelength of light emitted from the plurality of semiconductor light emitting elements (20),
a first distance (L1) between an upper surface (31u) of the wavelength conversion layer (31) and the substrate (10) in a first region (R1) between two adjacent semiconductor light emitting elements (20) in the semiconductor light emitting elements (20) being shorter than a second distance (L2) between the upper surface (31u) of the wavelength conversion layer (31) and the substrate (10) in a second region (R2) on the semiconductor light emitting elements (20).

2. The device (110, 110a) according to claim 1,
wherein in the first region (R1), a concave section (31ua) that is concave from the upper surface (31u) of the wavelength conversion layer (31) in a direction of the substrate (10) is formed, and the first distance (L1) between the deepest portion of the concave section (31ua) and the substrate (10) is shorter than the second distance (L2).

3. The device (110, 110a) according to claim 1 or 2,
wherein an absolute value of a difference between the first distance (L1) and the second distance (L2) is not less than 0.69 times and not more than 0.9 times the second distance (L2).

4. The device (110, 110a) according to any one of claims 1 to 3,
wherein the semiconductor light emitting elements (20) are provided on a mounting region (16) provided in the substrate (10), and
the second distance (L2) with respect to the semiconductor light emitting elements (20) positioned in a center section (16c) of the mounting region (16) is shorter than the second distance (L2) with respect to the semiconductor light emitting elements (20) positioned in an outer section (16e) of the mounting region (16), and the first distance (L1) with respect to the semiconductor light emitting element (20) positioned in the center section (16c) of the mounting region (16) is shorter than the first distance (L1) with respect to the semiconductor light emitting elements (20) positioned in the outer section (16e) of the mounting region (16).

5. The device (110, 110a) according to any one of claims 2 to 4,
wherein a depth of the concave section (31ua) in the center section (16c) is deeper than a depth of the concave section (31ua) in the outer section (16e).

6. The device (110a) according to any one of claims 1 to 5,
wherein the semiconductor light emitting elements (20) include
a first semiconductor element (20i),
a second semiconductor element (20j) separated from the first semiconductor element (20i) in a first direction parallel to an upper surface of the substrate (10),
a third semiconductor element (20k) separated from the first semiconductor element (20i) in a second direction parallel to the upper surface and intersecting the first direction, and
a fourth semiconductor element (201) separated from the third semiconductor element (20k) in the first direction and separated from the second semiconductor element (20j) in the second direction,
the wavelength conversion layer includes:
a first portion (P1) provided between the first semiconductor element (20i) and the second semiconductor element (20j);
a second portion (P2) provided between the first semiconductor element (20i) and the third semiconductor element (20k);
a third portion (P3) provided between the second semiconductor element (20j) and the fourth semiconductor element (201);
a fourth portion (P4) provided between the third semiconductor element (20k) and the fourth semiconductor element (201); and
a fifth portion (P5) provided between the first portion (P1) and the fourth portion (P4), and between the second portion (P2) and the third portion (P3), and
a third distance (L3) between the upper surface (31u) of the wavelength conversion layer (31) and the substrate (10) in the fifth portion (P5) is shorter than the first distance (L1).

7. The device (110a) according to claim 6,
wherein the concave section (31ua) in each of the first portion (P1), the second portion (P2), the third portion (P3) and the fourth portion (P4) has a groove shape and the concave section (31ua) in the fifth portion (P5) has substantially conical shape.
